# DEMANDE DE BREVET EUROPEEN

(11) **EP 1 873 918 A1**
(43) Date de publication de la demande: **02.01.2008**
(21) Numéro de dépôt: 07010849.3
(22) Date de dépôt: 01.06.2007
(51) Int. Cl.: H03K 19/003, G06F 1/12

(54) **Procédé de contrôle du temps d'évaluation d'une machine d'état**

(30) Priorité: 28.06.2006 FR 0605814
(71) Demandeur: STMICROELECTRONICS SA, 92120 Montrouge (FR)
(72) Inventeur: Murrillo, Laurent, Les Olives 13013 Marseille (FR); Tailliet, François, 13710 Fuveau (FR)
(74) Mandataire: Marchand, André

(57) **Abrégé**

L'invention concerne un procédé de protection d'une machine d'état (FSM) ayant un fonctionnement modélisé par un ensemble d'états reliés entre eux par des transitions, la machine d'état évaluant à chaque transition durant une phase d'évaluation des signaux de sortie (PO, SO) en fonction de signaux d'entrée (PI, SI) comprenant des signaux (PI) évalués lors d'une transition précédente, le procédé comprenant des étapes de détermination d'une durée minimale de chaque phase d'évaluation en fonction d'une durée minimale nécessaire à l'évaluation des signaux de sortie (PO, SO) en fonction des signaux d'entrée (PI, SI), et d'ajustement de la durée de chaque phase d'évaluation.

## Description

La présente invention concerne les machines d'état et en particulier celles utilisées dans les circuits intégrés.

Une machine d'état est une sorte d'automate dont le fonctionnement est modélisé par un ensemble d'états reliés entre eux par des transitions. Une machine d'état finie comporte un nombre fini d'états, chaque état étant déterminé par les valeurs d'un ensemble de signaux dites d'état. Le passage d'un état en cours à un état suivant relié à l'état en cours par une transition est effectué en fonction des signaux d'état.

Classiquement, une machine d'état comporte des signaux d'entrée et des signaux de sortie générés en fonction des signaux d'entrée à chaque transition déclenchée par un front actif d'un signal d'horloge. Les signaux d'entrée et sortie d'une machine d'état peuvent également être répertoriés en signaux primaires et signaux secondaires. Les signaux d'entrée primaires sont les signaux que la machine d'état reçoit de l' "extérieur". Les signaux de sortie primaires sont les signaux que la machine d'état envoie vers l'extérieur. Les signaux de sortie secondaires produits par la machine d'état sont mémorisés par exemple à l'aide de bascules pour servir de signaux d'entrée secondaires lors de la transition suivante.

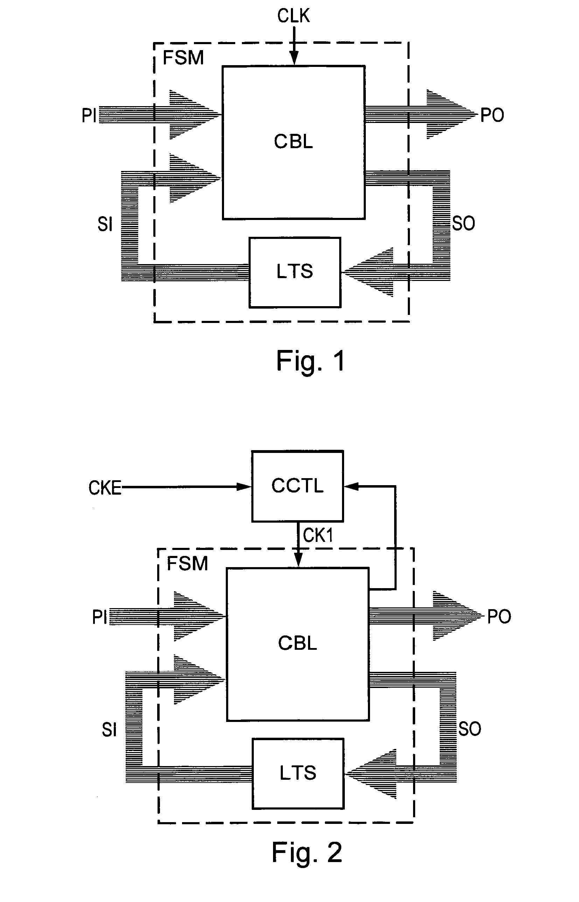

La figure 1 représente sous la forme de blocs une machine d'état. Sur la figure 1, la machine d'état FSM comprend un circuit de logique combinatoire CBL et un ensemble de verrous LTS. Toutes les sorties du circuit CBL sont connectées à l'ensemble de verrous LTS. Le circuit CBL comporte des entrées primaires PI et des sorties primaires PO. Le circuit CBL comporte également des entrées secondaires SI et des sorties secondaires SO. Les sorties secondaires SO sont connectées à l'ensemble de verrous LTS. Les verrous de l'ensemble LTS permettent de mémoriser l'état en cours de la machine d'état, c'est-à-dire les dernières valeurs des signaux de sortie primaires et secondaires générés par la machine d'état. Les signaux de sortie secondaires, une fois verrouillés par l'ensemble de verrous LTS, deviennent les signaux d'entrée secondaires SI utilisés par le circuit CBL pour exécuter la transition suivante.

De nombreux circuits électroniques utilisent des machines d'état. C'est le cas notamment de certaines mémoires comme les mémoires EEPROM (Electrically Erasable Programmable Read-Only Memory) à accès série.

Dans de telles applications, les transitions sont effectuées généralement en synchronisme avec un signal d'horloge CLK fourni par un bus de communication. Les signaux d'entrée primaires comprennent généralement des signaux reçus par la mémoire, ainsi que d'autres signaux internes à la mémoire. Les signaux de sortie primaires sont des signaux de commande contrôlant divers sous-ensembles de la mémoire (registres à décalage, décodeurs du plan mémoire, circuiterie de lecture, pompe de charge, etc.).

Certaines machines d'état de circuits intégrés sont réalisées à l'aide de réseaux logiques programmables PLA (Programmable Logic Array). Un réseau logique comprend un plan ET et un plan OU comportant chacun des portes logiques dites dynamiques. Le fonctionnement de telles portes logiques est cadencé par le signal d'horloge qui définit des phases de précharge et d'évaluation de l'état des portes logiques. Le signal d'horloge appliqué à la machine d'état correspond au signal d'horloge externe appliqué au circuit intégré lorsque ce dernier est sélectionné.

La phase de précharge est effectuée lorsque le signal d'horloge est à l'état bas. Au front montant du signal d'horloge qui déclenche la phase d'évaluation, les signaux d'entrée du réseau logique sont échantillonnés. Durant la phase d'évaluation, les plan ET et OU sont décodés pour obtenir les signaux de sortie de la machine d'état.

D'une manière générale, pour que la machine d'état fonctionne correctement, il ne faut pas que les signaux d'entrée changent d'état juste avant et pendant le front actif du signal d'horloge CLK. En effet, une fréquence d'horloge trop élevée (phase d'évaluation trop courte dans le cas d'un réseau logique) entraîne généralement la production de signaux de sortie erronés, avec pour conséquence un dysfonctionnement, voire un blocage de la machine d'état ou de l'ensemble (circuit intégré) dans lequel la machine d'état est intégrée. Dans le cas d'une mémoire, un tel dysfonctionnement peut se traduire par exemple par le décodage de commandes erronées, par la corruption de données en lecture (donc réversible) ou en écriture (irréversible), ou par le blocage de la mémoire, qui peut nécessiter une initialisation par une mise hors tension suivie d'une remise sous tension.

La perturbation du signal d'horloge peut être involontaire (par exemple bruit sur le signal d'horloge d'un bus d'accès, interprété comme un bref coup d'horloge), ou volontaire. Dans ce dernier cas, il peut s'agir de tentatives de perturber le fonctionnement d'un circuit sécurisé, afin de tenter de violer une fonction de sécurisation. En effet, certaines mémoires EEPROM adaptées à une application spécifique comportent des fonctions de sécurisation dont le fonctionnement peut être plus ou moins lié à la machine d'état.

La présente invention a pour but de protéger la machine d'état contre des perturbations du signal d'horloge appliqué à la machine d'état.

Cet objectif est atteint par la prévision d'un Procédé de protection d'une machine d'état ayant un fonctionnement modélisé par un ensemble d'états reliés entre eux par des transitions, la machine d'état évaluant à chaque transition durant une phase d'évaluation des signaux de sortie en fonction de signaux d'entrée comprenant des signaux évalués lors d'une transition précédente.

Selon un mode de réalisation de l'invention, le procédé comprend des étapes de détermination d'une durée minimale de chaque phase d'évaluation en fonction d'une durée minimale nécessaire à l'évaluation des signaux de sortie en fonction des signaux d'entrée, et d'ajustement de la durée de chaque phase d'évaluation.

Selon un mode de réalisation de l'invention, le procédé comprend une étape de génération d'un signal d'horloge interne synchronisé avec un signal d'horloge externe appliqué à la machine d'état pour déclencher une transition, le signal d'horloge interne ajustant la durée de chaque phase d'évaluation.

Selon un mode de réalisation de l'invention, le procédé comprend une étape de génération d'un signal d'alarme qui est dans un état actif si le signal d'horloge interne ne peut pas être synchronisé avec le signal d'horloge externe.

Selon un mode de réalisation de l'invention, dans lequel chaque phase d'évaluation est précédée d'une phase de précharge de la machine d'état au cours de laquelle les signaux d'entrée sont appliqués à la machine d'état, le procédé comprenant une étape d'ajustement de la durée de chaque phase de précharge à une durée minimale nécessaire à la précharge de la machine d'état.

Selon un mode de réalisation de l'invention, la machine d'état est réalisée à l'aide d'un réseau logique programmable, l'évaluation de la durée minimale de la phase d'évaluation étant effectuée en mesurant le temps de propagation d'un signal dans un chemin du réseau logique programmable configuré pour être le plus lent de tous les chemins possibles des signaux dans le réseau logique programmable. Selon un mode de réalisation de l'invention, la mesure du temps de propagation d'un signal dans le chemin le plus lent du réseau logique programmable est effectuée en détectant un changement d'état d'un signal de sortie du chemin le plus lent.

Selon un mode de réalisation de l'invention, le changement d'état du signal de sortie du chemin le plus lent déclenche la fin de la phase d'évaluation.

L'invention concerne également une machine d'état ayant un fonctionnement modélisé par un ensemble d'états reliés entre eux par des transitions, et évaluant à chaque transition durant une phase d'évaluation des signaux de sortie en fonction de signaux d'entrée comprenant des signaux générés lors d'une transition précédente.

Selon un mode de réalisation de l'invention, la machine d'état comprend un circuit de contrôle pour mesurer une durée minimale nécessaire à l'évaluation des signaux de sortie en fonction des signaux d'entrée, et pour ajuster la durée de la phase d'évaluation à la durée minimale mesurée.

Selon un mode de réalisation de l'invention, le circuit de contrôle génère un signal d'horloge interne synchronisé avec un signal d'horloge externe appliqué à la machine d'état pour déclencher une transition, le signal d'horloge interne ajustant la durée de chaque phase d'évaluation.

Selon un mode de réalisation de l'invention, le circuit de contrôle comprend des moyens pour générer un signal d'alarme qui est dans un état actif si le signal d'horloge interne ne peut pas être synchronisé avec le signal d'horloge externe.

Selon un mode de réalisation de l'invention, chaque phase d'évaluation est précédée par une phase de précharge de la machine d'état au cours de laquelle les signaux d'entrée sont appliqués à la machine d'état, le circuit de contrôle comprenant des moyens d'ajustement de la durée de chaque phase de précharge à une durée minimale nécessaire à la précharge de la machine d'état.

Selon un mode de réalisation de l'invention, la machine d'état comprend un réseau logique programmable recevant les signaux d'entrée de la machine d'état et générant les signaux de sortie de la machine d'état en fonction des signaux d'entrée.

Selon un mode de réalisation de l'invention, le circuit de contrôle reçoit le signal d'horloge externe et fournit le signal d'horloge interne au réseau logique programmable. Selon un mode de réalisation de l'invention, le circuit de contrôle comprend un chemin de signal du réseau logique programmable, qui est configuré pour être le plus lent de tous les chemins de signaux du réseau logique programmable, pour mesurer un temps de propagation minimal d'un signal dans le réseau logique programmable, la durée de la phase d'évaluation étant ajustée à la durée minimale mesurée.

Selon un mode de réalisation de l'invention, la machine d'état comprend des moyens pour détecter un changement d'état d'un signal de sortie du chemin le plus lent du réseau logique programmable, et déclencher la fin de la phase d'évaluation à la suite du changement d'état du signal de sortie du chemin le plus lent.

L'invention concerne également un réseau logique programmable recevant des signaux d'entrée et évaluant des signaux de sortie en fonction des signaux d'entrée durant une phase d'évaluation.

Selon un mode de réalisation de l'invention, le réseau logique comprend un circuit de contrôle pour mesurer une durée minimale nécessaire à l'évaluation des signaux de sortie en fonction des signaux d'entrée, et pour ajuster la durée de la phase d'évaluation à la durée minimale mesurée.

Selon un mode de réalisation de l'invention, le circuit de contrôle génère un signal d'horloge interne qui ajuste la durée de la phase d'évaluation.

Selon un mode de réalisation de l'invention, la phase d'évaluation est précédée d'une phase de précharge au cours de laquelle les signaux d'entrée sont appliqués au réseau logique programmable, le circuit de contrôle comprenant des moyens d'ajustement de la durée de la phase de précharge à une durée minimale nécessaire à la précharge des signaux d'entrée dans le réseau logique programmable.

Selon un mode de réalisation de l'invention, le circuit de contrôle comprend un chemin de signal du réseau logique programmable, qui est configuré pour être le plus lent de tous les chemins de signaux du réseau logique programmable, pour mesurer un temps de propagation minimal d'un signal dans le réseau logique programmable, la durée de la phase d'évaluation étant ajustée à la durée minimale mesurée.

Selon un mode de réalisation de l'invention, le réseau logique comprend des moyens pour détecter un changement d'état d'un signal de sortie du chemin le plus lent du réseau logique programmable, et déclencher la fin de la phase d'évaluation à la suite du changement d'état du signal de sortie du chemin le plus lent.

Ces objets, caractéristiques et avantages ainsi que d'autres de la présente invention seront exposés plus en détail dans la description suivante d'un mode de réalisation de l'invention, faite à titre non limitatif en relation avec les figures jointes parmi lesquelles :
- la figure 1 décrite précédemment représente sous la forme de blocs une machine d'état selon l'art antérieur,
- la figure 2 représente sous la forme de blocs une machine d'état selon l'invention,
- la figure 3 représente sous la forme de blocs un réseau logique programmable,
- les figures 4 à 7 sont des circuits électriques de blocs du réseau logique programmable représenté sur la figure 4,
- la figure 8 illustre sous la forme de chronogrammes le fonctionnement du circuit représenté sur la figure 8,
- la figure 9 représente un dispositif de génération d'un signal d'horloge interne selon l'invention,
- la figure 10 est un circuit électrique du dispositif de génération représenté sur la figure 8,
- la figure 11 illustre sous la forme de chronogrammes le fonctionnement du dispositif de génération représenté sur la figure 9,
- la figure 12 est un circuit électrique d'un ensemble de verrous mémorisant l'état en cours de la machine d'état représentée sur la figure 2.

La figure 2 représente une machine d'état selon l'invention. Sur la figure 2, la machine d'état FSM comprend un circuit de logique combinatoire CBL et un ensemble de verrous LTS. Toutes les sorties du circuit CBL sont connectées à l'ensemble de verrous LTS. Le circuit CBL comporte des entrées primaires PI et des sorties primaires PO. Le circuit CBL comporte également des entrées secondaires SI et des sorties secondaires SO. Les sorties secondaires SO sont connectées à l'ensemble de verrous LTS. Les verrous de l'ensemble LTS permettent de mémoriser les états de la machine d'état, c'est-à-dire les valeurs des signaux de sortie primaires et secondaires générés par la machine d'état. Les signaux de sortie secondaires SO, une fois mémorisés par l'ensemble de verrous LTS, deviennent les signaux d'entrée secondaires SI utilisés par le circuit CBL pour exécuter la transition suivante.

Selon un mode de réalisation de l'invention, la machine d'état comprend un circuit de contrôle du signal d'horloge CCTL fournissant au circuit CBL un signal d'horloge interne CK1 à partir d'un signal d'horloge externe CKE. Le signal d'horloge interne CK1 détermine la durée d'une phase d'évaluation des signaux de sortie de la machine d'état. En particulier, le signal d'horloge interne CK1 ajuste la durée de la phase d'évaluation à une durée minimale nécessaire à l'évaluation correcte des signaux de sortie (PO, SO). De cette manière, les risques de dysfonctionnements de la machine d'état résultant de perturbations du signal d'horloge externe sont évités.

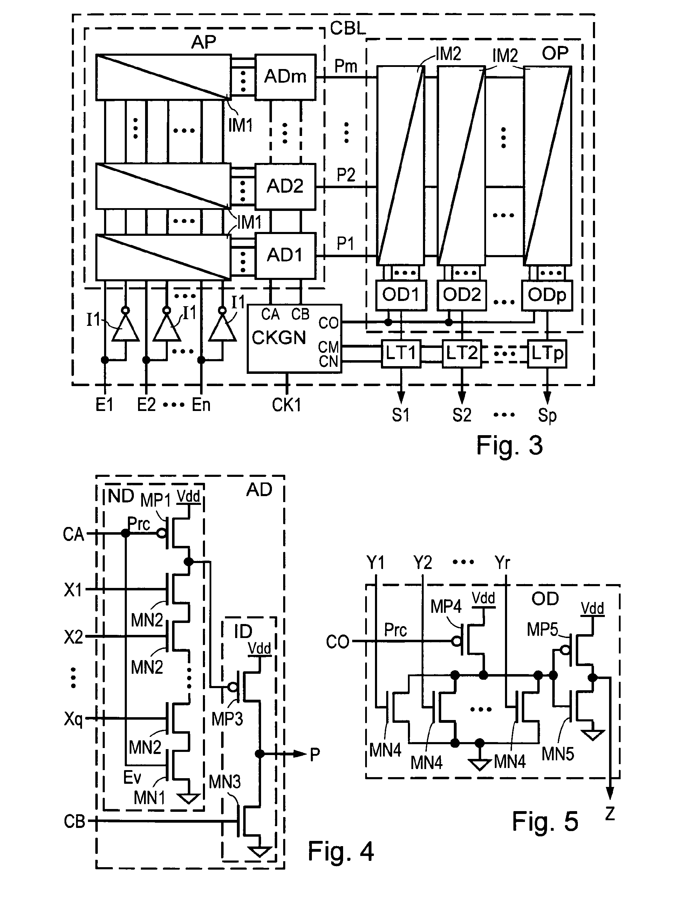

La figure 3 représente un mode de réalisation du circuit de logique combinatoire CBL. Sur la figure 3, le circuit CBL reçoit des signaux d'entrée E1, E2, ... En et fournit des signaux de sortie S1, S2, ... Sp résultant de l'application de fonctions logiques aux signaux E1, E2, ... En.

Le circuit CBL est réalisé à l'aide d'un réseau logique programmable PLA (Programmable Logic Array) qui reçoit les signaux d'entrée E1-En, et qui fournit les signaux de sortie S1-Sp. Les signaux S1-Sp sont de façon déterminée la somme de produits des signaux E1-En.

Classiquement, le réseau logique programmable comprend un étage d'entrée AP, également appelé "plan ET" appliquant des fonctions logiques ET ou produit aux signaux d'entrée E1-En, et un étage de sortie OP, également appelé "plan OU" appliquant des fonctions OU ou somme aux signaux de sortie P1, P2, ...Pm de l'étage AP.

Le réseau logique programmable comprend des inverseurs I1 recevant les signaux d'entrée E1-En et dont les sorties sont connectées à des entrées de l'étage d'entrée AP. Ainsi, l'étage d'entrée reçoit à la fois les signaux d'entrée et les signaux d'entrée inversés. Les sorties du réseau logique programmable constituées par les sorties de l'étage de sortie OP sont connectées à des verrous de sortie LT1, LT2, ... LTp, qui mémorisent chacun un signal de sortie S1-Sp du circuit CBL. Le réseau logique programmable comprend un circuit de génération de signaux d'horloge CKGN cadençant les étages d'entrée AP et de sortie OP, ainsi que les verrous LT1-LTp.

L'étage d'entrée AP du circuit CBL comprend plusieurs circuits logiques produit AD1, AD2, ... ADm réalisant chacun une fonction logique ET à plusieurs entrées et une sortie P1, P2, ..., Pm, et des matrices d'interconnexion IM1 connectant chacune sélectivement certaines entrées de l'étage d'entrée AD regroupant les entrées E1-En du circuit CBL et les entrées inversées de ces dernières, à certaines entrées d'un des circuits logiques produit AD1-ADm. Ainsi, si le circuit CBL comporte n entrées E1-En, et si chaque circuit AD1-ADm comporte au maximum q entrées, chaque matrice d'interconnexion IM1 comprend 2n entrées et q sorties. Généralement, le nombre q d'entrées de chaque circuit produit est au maximum égal au nombre n d'entrées du réseau logique programmable. Les sorties P1-Pm des circuits AD1-ADm constituent les sorties de l'étage d'entrée AP.

L'étage de sortie OP du circuit CBL comprend plusieurs circuits logiques somme OD1, OD2, ... ODp réalisant chacun une fonction OU ou somme, à plusieurs entrées et une sortie, et des matrices d'interconnexion IM2 connectant chacune sélectivement certaines sorties P1-Pm de l'étage d'entrée AD à certaines entrées d'un des circuits logiques produit OD1-ODp. Si le circuit CBL comporte m circuits AD1-ADm, et si chaque circuit logique somme OD1-ODp comporte au maximum r entrées, chaque matrice d'interconnexion IM2 comprend m entrées et r sorties. En général le nombre r d'entrées des circuits somme est inférieur au nombre m de circuits somme. Les sorties des circuits OD1-ODp constituent les sorties de l'étage de sortie OP et sont connectées chacune à l'entrée d'un verrou LT1-LTp.

La configuration des matrices d'interconnexion IM1, IM2 détermine la fonction logique réalisée par le circuit CBL.

Dans la description qui suit, les références commençant par "MN" sont utilisées pour désigner un transistor MOS à canal N et les référence commençant par "MP" sont utilisées pour désigner un transistor MOS à canal P.

La figure 4 est un schéma électrique d'un circuit logique produit AD de l'étage d'entrée AP. Sur la figure 4, le circuit AD comprend une branche d'entrée ND réalisant une fonction logique ET inversée dynamique, et une branche de sortie ID réalisant la fonction d'un inverseur dynamique, dont la sortie constitue une sortie P du circuit AD.

La branche d'entrée ND du circuit AD comprend un groupe de plusieurs transistors MN2 agencés en série. La grille de chaque transistor MN2 est connectée à une entrée X1-Xq du circuit AD. Le groupe de transistors MN2 comprend un premier transistor MN2 dont la grille est connectée à une première entrée X1 du circuit AD, et dont le drain est connecté au drain d'un transistor MP1. La grille du transistor MP1 reçoit un signal d'horloge CA, et le drain de ce transistor reçoit une tension d'alimentation Vdd. Le transistor MP1 assure la précharge des transistors MN2. Le groupe de transistors MN2 comprend un dernier transistor MN2 dont la grille est connectée à une dernière entrée Xq du circuit AD, et dont la source est connectée au drain d'un transistor MN1. La grille du transistor MN1 reçoit le signal d'horloge CA, et la source de ce transistor est connectée à la masse. Le noeud de connexion du drain du transistor MP1 au drain du premier transistor MN2 constitue la sortie de la fonction logique ET inversée dynamique. Le transistor MN1 permet l'évaluation de la fonction logique ET inversée dynamique réalisée par les transistors MN2, à la suite de la précharge de ces derniers. Le signal d'horloge CA détermine des phases de précharge (CA = 0) et d'évaluation (CA = 1) de la branche d'entrée ND du circuit AD.

La branche de sortie ID du circuit AD comprend un transistor MP3 dont la grille est connectée à la sortie de la branche d'entrée ND, c'est-à-dire au drain du transistor MP1 et au drain du premier transistor MN2. La source du transistor MP3 reçoit la tension d'alimentation Vdd. La branche de sortie ID comprend un transistor MN3 dont la grille reçoit un signal d'horloge CB, dont la source est à la masse et dont le drain est connecté au drain du transistor MP3 et à la sortie P du circuit AD.

Le transistor MN3 déclenche les phases de précharge, puis d'évaluation de la fonction logique d'inversion dynamique réalisée par le transistor MP3. Le signal d'horloge CB détermine des phases de précharge (CB = 1) et d'évaluation (CB = 0) de la branche de sortie ID du circuit AD.

La figure 5 est le schéma électrique d'un circuit logique somme OD de l'étage de sortie OP. Sur la figure 5, le circuit OD comprend plusieurs transistors MN4 agencés en parallèle, dont la source est connectée à la masse. La grille de chacun des transistors MN4 est connectée à une entrée Y1-Yr du circuit OD. Le drain des transistors MN4 est connecté au drain d'un transistor MP4 dont la source reçoit la tension d'alimentation Vdd, et dont la grille reçoit un signal d'horloge CO. Les transistors MN4 réalisent une fonction OU inversée dynamique. Le drain de chacun des transistors MN4 forme une sortie de la fonction, qui est connectée à l'entrée d'un inverseur. L'inverseur est formé de deux transistors MN5, MP5 dont les grilles constituent l'entrée de l'inverseur. La source du transistor MN5 est connectée à la masse, tandis que la source du transistor MP5 reçoit la tension d'alimentation Vdd. Les drains des transistors MN5 et MP5 qui constituent la sortie de l'inverseur, fournissent un signal de sortie Z du circuit OD.

Le transistor MP4 permet l'évaluation de la fonction logique OU inversée dynamique réalisée par les transistors MN4, à la suite de la précharge de ces derniers. Le signal d'horloge CO commandant le transistor MP4 détermine des phases de précharge (CO = 0) et d'évaluation (CO = 1) du circuit OD.

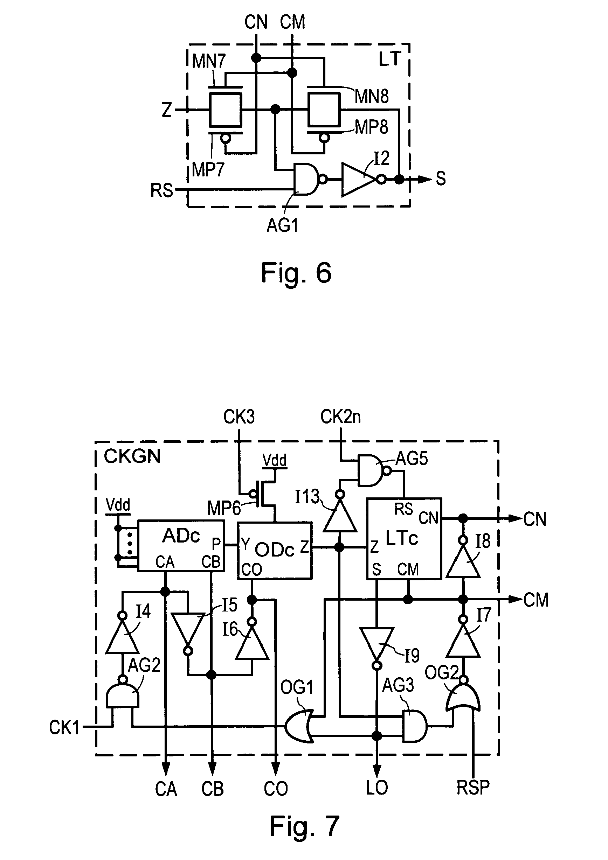

La figure 6 est le schéma électrique d'un verrou LT identique aux verrous LT1-LTp. Le verrou LT comprend des transistors MN7, MP7 montés en parallèle. Le drain du transistor MN7 et la source du transistor MP7 reçoivent le signal de sortie Z d'un circuit logique produit OD. La grille du transistor MN7 est commandée par un signal d'horloge CM, tandis que la grille du transistor MP7 est commandée par un signal d'horloge CN. La source du transistor MN7 et le drain du transistor MP7 sont connectés à l'entrée d'une porte logique AG1 de type ET inversée, ainsi qu'à la source d'un transistor MN8 et au drain d'un transistor MP8. La grille du transistor MN8 reçoit le signal d'horloge CN, tandis que la grille du transistor MP8 reçoit le signal d'horloge CM. Une autre entrée de la porte AG1 reçoit un signal d'initialisation RS. La sortie de la porte AG1 est connectée à l'entrée d'un inverseur I2 dont la sortie est connectée au drain du transistor MN8 et à la source du transistor MP8. La sortie de l'inverseur I2 constitue une sortie S du verrou LT.

Les signaux d'horloge CM et CN déterminent des phases de charge (CM = 1, CN = 0) et de verrouillage (CM = 0, CN = 1) du verrou LT. Le verrou LT à l'état verrouillé (signaux CM et CN respectivement à 0 et 1) peut être initialisé à 0 (S = 0) en appliquant un signal d'initialisation RS à 0.

La figure 7 est un schéma électrique du circuit de génération de signaux d'horloge CKGN du circuit CBL. Le circuit CKGN utilise un circuit logique produit ADc, un circuit logique somme ODc, et un verrou LTc du réseau logique programmable constituant le circuit CBL. Toutes les entrées X1-Xq du circuit ADc sont connectées à la source de tension d'alimentation Vdd. La sortie P du circuit ADc est connectée à l'entrée Y du circuit ODc. La sortie Z du circuit ODc est connectée à l'entrée Z du verrou LTc. Le circuit ODc (source du transistor MP5) reçoit la tension d'alimentation Vdd par l'intermédiaire d'un transistor MP6 commandé par un signal CK3. La sortie S du verrou LTc fournit un signal de sortie LO du circuit CKGN par l'intermédiaire d'un inverseur I9.

Le circuit CKGN comprend une porte logique AG2 de type ET inversée recevant le signal d'horloge interne CK1. La sortie de la porte AG2 est connectée à l'entrée d'un inverseur I4 dont la sortie fournit le signal d'horloge CA qui est appliqué aux circuits produit ADc, AD1-ADm de l'étage d'entrée AP, incluant le circuit produit ADc du circuit CKGN.

Le circuit CKGN comprend un inverseur 15 recevant le signal d'horloge CA et fournissant le signal d'horloge CB également appliqué aux circuits produit AD1-ADm et ADc. Le circuit CKGN comprend un inverseur I6 recevant le signal d'horloge CB et fournissant le signal d'horloge CO appliqué aux circuits somme ODc, OD1-ODp de l'étage de sortie OP, incluant le circuit somme ODc du circuit CKGN.

Le circuit CKGN comprend une porte logique AG3 de type ET dont une entrée est connectée à la sortie Z du circuit ODc et dont la sortie est connectée à l'entrée d'une porte logique OG2 de type OU inversée. Une autre entrée de la porte OG2 reçoit un signal d'initialisation RSP et la sortie de cette porte est connectée à l'entrée d'un inverseur 17 dont la sortie fournit le signal d'horloge CM qui est appliqué au verrou LTc et à une entrée d'une porte logique OG1 de type OU. La sortie de la porte OG1 est connectée à une entrée de la porte AG2.

La sortie Z du circuit ODc est également reliée à l'entrée d'une porte logique AG5 de type ET par l'intermédiaire d'un inverseur I13. Une autre entrée de la porte AG5 reçoit un signal d'horloge CK2n. La sortie de la porte AG5 est connectée à l'entrée d'initialisation RS du verrou LTc.

Le circuit CKGN comprend un inverseur I8 recevant le signal d'horloge CM et fournissant le signal d'horloge CN appliqué aux verrous LTc et LT1-LTp. La sortie S du verrou LTc est connectée à l'entrée d'un inverseur I9 dont la sortie est connectée à une entrée de la porte AG3, à une entrée de la porte OG1, ainsi qu'à une sortie LO du circuit CKGN.

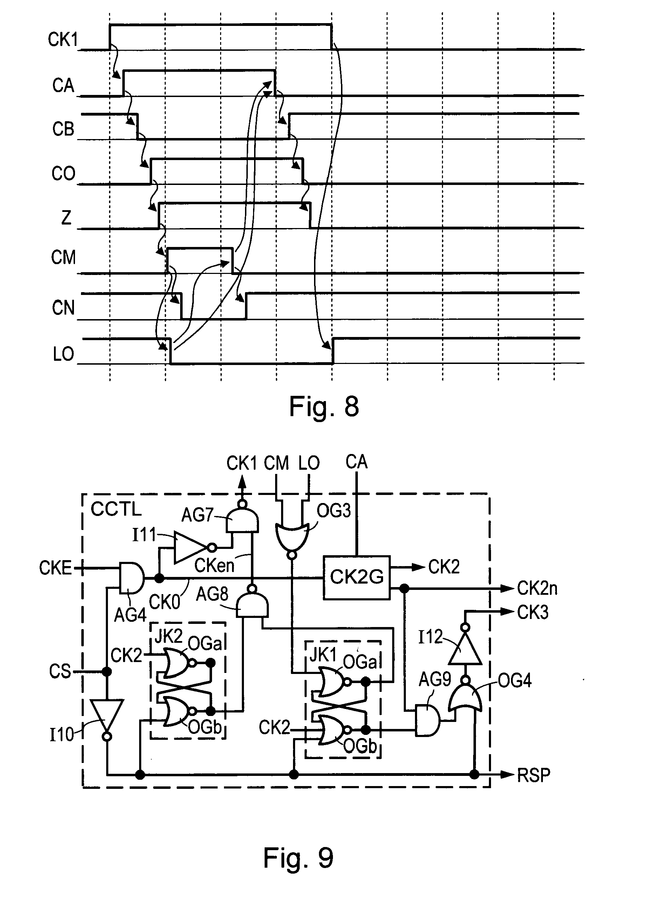

La figure 8 illustre sous la forme de chronogrammes le fonctionnement du circuit de génération de signaux d'horloge CKGN. La figure 8 représente les chronogrammes des signaux d'horloge CK1, CA, CB, CO, CM et CN, du signal de sortie Z du circuit ODc et du signal de sortie LO du verrou LTc du circuit CKGN. Dans un état initial, les signaux d'horloge CA, CO, et CM, et le signal de sortie Z du circuit ODc sont à 0, tandis que les signaux d'horloge CB et CN et le signal de sortie LO du verrou LTc sont à 1. Il en résulte que la précharge de l'étage d'entrée AP et de l'étage de sortie OP démarre.

A l'arrivée d'un front montant du signal d'horloge CK1, à l'état initial du circuit CKGN, le signal d'horloge CA passe à 1, marquant la fin de la précharge de l'étage d'entrée AP et donc le début de l'évaluation des branches d'entrée ND de l'étage d'entrée. A la fin de la précharge de l'étage d'entrée AP, le signal d'horloge CB en sortie de l'inverseur I5 passe alors à 0. Les sorties P1-Pm de l'étage d'entrée AP sont alors valides. En fait, les sorties P1-Pm ne sont valides qu'un certain temps après le début de l'évaluation de l'étage d'entrée en raison du temps de propagation des signaux d'entrée E1-En dans les branches d'entrée ND. Pour être certain que ce temps de propagation est terminé, et donc que les sorties P1-Pm de l'étage d'entrée AD sont valides, le circuit ADc du circuit CKGN comporte un nombre d'entrées supérieur au nombre n d'entrées E1-En du circuit CBL, c'est-à-dire au nombre q d'entrées de chaque circuit AD1-ADp. Le circuit ADc est ainsi le plus lent à fournir un signal de sortie P valide, de tous les circuits produit AD1-ADm, ADc du circuit CBL.

Lorsque la sortie du circuit ADc bascule, le signal CO passe à 1, déclenchant la fin de la précharge de l'étage de sortie OP et donc le début de la phase d'évaluation de cet étage. Le signal de sortie P du circuit produit ADc du circuit CKGN passe alors à 1. Pour être certain que le temps de propagation des signaux dans l'étage de sortie OP est terminé, et donc que les sorties Z1-Zp de l'étage de sortie OP sont valides, le nombre d'entrées du circuit ODc est choisi supérieur au nombre total de circuits ADc, AD1-ADp utilisés, une entrée Y du circuit ODc étant connectée à la sortie P du circuit ADc, tandis que toutes les autres entrées du circuit ODc sont à la masse. De cette manière, lorsque la sortie Z du circuit ODc bascule, il est certain que toutes les sorties Z1-Zp des circuits OD1-ODp ont eu le temps de basculer.

Les deux entrées de la porte AG3 sont alors à 1. Il en résulte que le signal d'horloge CM passe à 1. Le passage à 1 du signal d'horloge CM entraîne le passage à 0 du signal d'horloge CN au travers de l'inverseur I8 et un changement d'état du signal de sortie LO de l'inverseur I9 à la sortie du verrou LTc qui passe à 0.

Le passage à 0 du signal LO entraîne le passage à 0 du signal d'horloge CM, puis le passage à 1 du signal d'horloge CN. Les signaux de sortie Z, Z1-Zp des circuits ODc, OD1-ODp sont ainsi verrouillés par les verrous LTc, LT1-LTp dès qu'ils sont valides. Le changement d'état du signal CM entraîne le passage à 0 du signal CA, par l'intermédiaire des portes OG1, AG2 et de l'inverseur I4. Le passage à 0 du signal CA entraîne le passage à 1 du signal CB, puis le passage à 0 du signal CO, et enfin le passage à 0 du signal de sortie Z du circuit ODc. La phase d'évaluation des étages d'entrée AP et de sortie OP est donc arrêtée pour redémarrer une nouvelle phase de précharge des étages d'entrée AP et de sortie OP. Le passage à 0 du signal LO déclenche donc la fin de la phase d'évaluation dans les étages d'entrée AP et de sortie OP, émulée par les circuits ADc et ODc.

Au front descendant du signal d'horloge CK1, un front montant apparaît dans le signal d'horloge CK2n qui initialise le verrou LTc. Le signal de sortie LO de l'inverseur 19 repasse alors à 1.

Pendant la nouvelle phase de précharge, les signaux d'entrée E1-En prennent une nouvelle valeur correspondant à un nouvel état d'entrée de la machine d'état FSM, mémorisé par l'ensemble de verrous LTS. Ensuite, le processus décrit précédemment recommence pour exécuter une nouvelle transition de la machine d'état.

Il est à noter que pour que la machine d'état fonctionne correctement, il faut que toutes les entrées E1-En soient stables un peu avant la montée du signal d'horloge CK1, jusqu'à au moins la descente du signal d'horloge CM.

Le dernier événement avant l'arrivée du front descendant du signal d'horloge primaire CK1 est le passage à 0 du signal d'horloge CO. Si le front descendant du signal d'horloge CK1 apparaît avant la retombée du signal CO, en raison d'une perturbation fortuite ou volontaire, le fonctionnement du circuit CKGN sera perturbé et va générer des signaux d'horloge CA, CB, CO, CM, CN ne permettant pas de synchroniser correctement les circuits produit AD, les circuits somme OD et les verrous LT du circuit CBL. Le circuit CBL va donc générer des signaux de sortie erronés.

Pour supprimer ce risque, la machine d'état comprend selon un mode de réalisation de l'invention un circuit de contrôle de signal d'horloge CCTL. Un exemple de circuit de contrôle de signal d'horloge CCTL est représenté sur la figure 9. Le circuit CCTL comprend une porte logique AG4 de type ET dont une entrée reçoit le signal d'horloge externe CKE et une autre entrée reçoit un signal de sélection CS du composant intégrant la machine d'état. De cette manière, le signal CK0 en sortie de la porte AG4 présente des impulsions d'horloge uniquement lorsque le composant est sélectionné. Le signal CK0 est appliqué à l'entrée d'un inverseur I11 et à l'entrée d'un circuit de génération de signaux secondaires d'horloge CK2G fournissant deux signaux d'horloge secondaires CK2 et CK2n complémentaires l'un de l'autre. La sortie de l'inverseur I11 est connectée à l'entrée d'une porte logique AG7 de type ET inversée dont la sortie fournit le signal d'horloge interne CK1 qui est appliqué en entrée du circuit de génération de signaux d'horloge CKGN.

Le circuit CCTL comprend deux bascules JK1, JK2 de type JK comportant classiquement deux portes logiques OGa, OGb de type OU inversé, la sortie de chaque porte OGa, OGb étant connectée à une entrée de l'autre porte OGb, OGa. Les entrées non connectées de chaque porte OGa, OGb constituent une entrée de la bascule et la sortie de chaque porte constitue une sortie de la bascule. Le circuit CCTL comprend une porte logique OG3 de type OU inversé dont les entrées reçoivent les signaux CM et LO fournis par le circuit CKGN et dont la sortie est connectée à l'entrée de la porte OGa de la bascule JK1. La porte OGb de la bascule JK1 reçoit le signal CK2 ainsi qu'un signal RSP correspondant au signal de sélection CS préalablement inversé par un inverseur I10. La sortie de la porte OGa de la bascule JK1 est connectée à l'entrée d'une porte logique AG8 de type ET inversé, dont la sortie fournit un signal CKen qui est appliqué à l'entrée de la porte AG7. La sortie de la porte OGb de la bascule JK1 est connectée à l'entrée d'une porte logique AG9 de type ET dont une autre entrée reçoit le signal CK2n. La sortie de la porte AG9 est connectée à l'entrée d'une porte logique OG4 de type OU inversé. Une autre entrée de la porte OG4 reçoit le signal RSP. La sortie de la porte OG4 fournit le signal CK3 au circuit CKGN par l'intermédiaire d'un inverseur I12.

L'entrée de la porte OGa de la bascule JK2 reçoit le signal CK2. L'entrée de la porte OGb de la bascule JK2 est connectée à la sortie de l'inverseur I10 qui fournit le signal RSP au circuit CKGN. La sortie de la porte OGb de la bascule JK2 est connectée à l'entrée de la porte AG8.

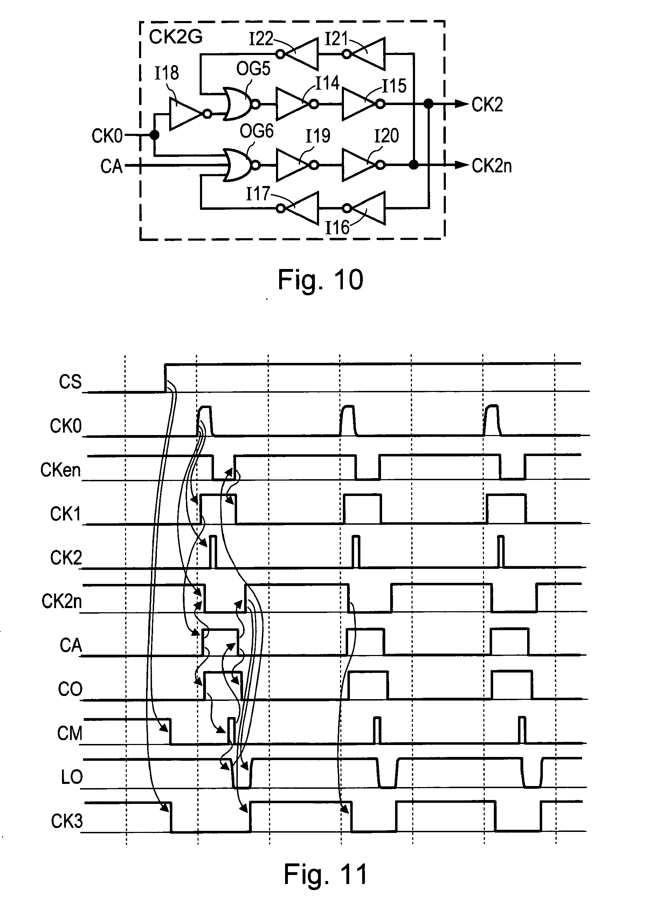

La figure 10 représente le circuit de génération de signaux d'horloge secondaires CK2G. Le circuit CK2G comprend deux portes logique OG5, OG6 de type OU inversé, la porte OG6 recevant le signal CK0, et la porte OG5 recevant le signal CK0 au travers d'un inverseur I18. La sortie de la porte OG5 est connectée à deux inverseurs I14, I15 montés en cascade. La sortie de l'inverseur I15 fournit le signal CK2 et est reliée à une entrée de la porte OG6 par l'intermédiaire de deux inverseurs I16, I17 montés en cascade. La sortie de la porte OG6 est connectée à deux inverseurs I19, I10 montés en cascade. La sortie de l'inverseur I10 fournit le signal CK2n et est reliée à une entrée de la porte OG5 par l'intermédiaire de deux inverseurs I21, I22. La porte OG6 reçoit également en entrée le signal CA fourni par le circuit CKGN. Le circuit CK2G permet de générer des impulsions de signaux d'horloge non recouvrantes (les signaux CK2 et CK2n ne sont jamais à 1 simultanément).

La figure 11 illustre sous la forme de chronogrammes le fonctionnement du circuit de contrôle de signal d'horloge CCTL. La figure 10 représente les chronogrammes des signaux CS, CK0, CKen, CK1, CK2, CK2n, CA, CO, LO, CM et CK3. Dans un état initial, le signal de sélection CS est à 0 : le composant intégrant le réseau logique programmable n'est pas sélectionné. Les signaux CK0, CK2, CA, CO sont à 0, tandis que les signaux CK2n, LO, CM et CK3 sont à 1.

Le signal CK0 présente des impulsions correspondant aux impulsions du signal d'horloge externe CKE, à partir du moment où le signal de sélection CS passe à 1. Le signal CK2 et le signal CK2n présentent une impulsion à chaque impulsion du signal CK0. Les impulsions du signal CK2 sont plus courtes que celles du signal CK0, tandis que celles du signal CK2n sont plus longues que celles du signal CK0.

Le passage à 1 du signal CS entraîne le passage à 0 des signaux CM, puis CK3. Ainsi, le signal CK3 passe à 1 dès que le signal LO passe à 0, tandis que le signal CM est à l'état bas. Par ailleurs, l'inverseur I13 en sortie du circuit ODc est contrôlé par le signal CK3 pendant la phase d'évaluation afin de conditionner la montée du signal CM uniquement lorsque le signal CK3 est à 0. Le non recouvrement des signaux d'horloge CM et CK3 (signaux simultanément à 1) est donc assuré.

Le signal CA généré par le circuit CKGN à partir du signal CK1, passe à 1 à l'arrivée d'un front montant du signal d'horloge primaire CK1, marquant la fin de la phase de précharge de l'étage d'entrée AP et donc le début de la phase d'évaluation des branches d'entrée ND de l'étage d'entrée AP. Le passage à 1 du signal CA entraîne le passage à 1 du signal CO, marquant le début de la phase d'évaluation de l'étage de sortie OP. Le passage à 1 du signal CO entraîne un peu plus tard le passage à 1 de la sortie Z du circuit ODc, et donc le passage à 1 du signal CM. Le passage à 1 du signal CM est suivi par le passage à 0 du signal LO en sortie du verrou LTc.

Le passage à 1 du signal CK2 entraîne le passage à 0 du signal CKen au travers des bascules JK1 et JK2. Le passage à 0 du signal CKen force à 1 le signal d'horloge CK1. De cette manière, il est certain que le signal d'horloge CK1 cadençant le circuit CBL ne passe pas à 0 avant la fin de la phase de chargement des verrous LT1-LTp.

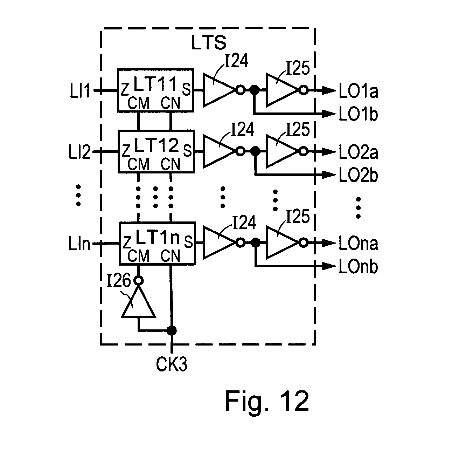

La figure 12 représente l'ensemble de verrous LTS. L'ensemble de verrous LTS comprend n branches. Chaque branche i (i étant un nombre entier variant de 1 à n) comporte une entrée LIi connectée à une sortie S1-Sp du circuit CBL, un verrou LTli connecté à l'entrée LIi, et deux inverseurs I24, 125 montés en cascade et connectés à une sortie du verrou LT1i. La sortie de chacun des inverseurs I24, I25 constitue une sortie LOia LOib de la branche. Chaque verrou LTli est du type représenté sur la figure 6. Les entrées de signal d'horloge CN, CM de chacun des verrous reçoivent le signal CK3 et ce même signal préalablement inversé par un inverseur 126. Le signal CK3 est donc utilisé pour déclencher la mémorisation des signaux de sortie des verrous LT1-LTp dans l'ensemble de verrous LTS. Comme les signaux d'horloge CM et CK3 ne se recouvrent pas (ne sont pas simultanément à 1), on est assuré que la phase de mémorisation par les verrous LTS est déclenchée à la suite de la phase de mémorisation dans les verrous LT1-LTp.

Grâce à ces dispositions, les fronts actifs du signal d'horloge externe CKE (CK0) ne sont utilisés que pour synchroniser le signal d'horloge interne CK1 utilisé pour déclencher et stopper la phase d'évaluation. L'interruption de la phase d'évaluation, c'est-à-dire le passage à 0 du signal d'horloge CK1, est en fait déclenchée en déterminant le temps de propagation des signaux dans les circuits ADc et ODc des étages d'entrée AP et de sortie OP. Les circuits ADc et ODc sont configurés pour que le temps de propagation dans ces circuits soit le plus long de tous les circuits des étages d'entrée et de sortie. Ainsi, lorsque la sortie du verrou LTc en sortie du circuit ODc change d'état, il est certain que les signaux mémorisés par les autres verrous LT1-LTp sont des signaux stabilisés obtenus à la suite d'une phase d'évaluation de durée suffisante.

Si un front actif du signal d'horloge CK0 apparaît avant que les signaux de sortie Z de l'étage de sortie OP soient mémorisés dans les verrous LT1-LTp (signal CM à 1 et signal CN à 0), le front actif du signal d'horloge est ignoré. Le circuit de contrôle CCTL peut ainsi comprendre un circuit de génération d'alarme pour émettre un signal d'erreur si un front actif du signal d'horloge CK0 apparaît avant que les signaux de sortie Z de l'étage de sortie OP soient mémorisés dans les verrous LT1-LTp (signal CM à 1 et signal CN à 0 ou signal LO à 0). Le signal d'erreur peut ainsi être généré par exemple à l'aide d'une porte logique de type ET recevant le signal CK0 et le signal LO préalablement inversé, et d'une bascule JK connectée à la sortie de la porte logique pour mémoriser la valeur du signal d'erreur, et donc la détection d'une erreur de signal d'horloge. On peut également prévoir de ne générer un signal d'alarme que si le signal d'horloge interne CK1 ne peut pas être synchronisé avec le signal d'horloge externe.

Si un front actif du signal d'horloge apparaît dès que le signal LO est remonté à 1, la durée de la phase de précharge peut être insuffisante pour que les circuits d'entrée AP et de sortie OP soient correctement préchargés. Le circuit de contrôle CCTL peut ainsi comprendre un circuit qui retarde le passage à 1 du signal CA à la suite du passage à 1 du signal d'horloge CK1. La valeur du retard appliqué au signal CA correspond à la durée minimale nécessaire à la précharge des signaux dans l'étage d'entrée AP.

Il apparaîtra clairement à l'homme de l'art que la présente invention est susceptible de diverses variantes de réalisation et d'applications. En particulier, la machine d'état peut être réalisée avec d'autres circuits qu'un réseau logique programmable. L'invention s'applique plus généralement à toutes les machines d'état imposant une durée minimum pour évaluer les signaux de sortie en fonction des signaux d'entrée. L'invention s'applique également aux réseaux logiques programmables qui ne sont pas nécessairement utilisés pour réaliser une machine d'état.

Pour mesurer la durée minimum de la phase d'évaluation, il n'est pas nécessaire d'utiliser un chemin de signal dans le réseau logique programmable. Cette durée peut être déterminée a priori en fonction des traitements de signaux effectués par la machine d'état. Il importe simplement que la fin de la phase d'évaluation ne soit pas déclenchée par un événement externe tel qu'un changement d'état d'un signal d'horloge externe.

Il n'est pas non plus indispensable d'ajuster la durée de la phase de précharge, étant donné que les signaux mettent un certain temps pour se propager dans le réseau logique programmable. Ainsi, la précharge de l'étage d'entrée AP peut commencer avant la fin de la mémorisation des signaux de sortie dans les verrous LTS.

## Revendications

1. Procédé de protection d'une machine d'état (FSM) ayant un fonctionnement modélisé par un ensemble d'états reliés entre eux par des transitions, la machine d'état évaluant à chaque transition durant une phase d'évaluation des signaux de sortie (PO, SO) en fonction de signaux d'entrée (PI, SI) comprenant des signaux (PI) évalués lors d'une transition précédente,
**caractérisé en ce qu'**il comprend des étapes de détermination d'une durée minimale de chaque phase d'évaluation en fonction d'une durée minimale nécessaire à l'évaluation des signaux de sortie (PO, SO) en fonction des signaux d'entrée (PI, SI), et d'ajustement de la durée de chaque phase d'évaluation.

2. Procédé selon la revendication 1, comprenant une étape de génération d'un signal d'horloge interne (CK1) synchronisé avec un signal d'horloge externe (CKE) appliqué à la machine d'état (FSM) pour déclencher une transition, le signal d'horloge interne ajustant la durée de chaque phase d'évaluation.

3. Procédé selon la revendication 2, comprenant une étape de génération d'un signal d'alarme qui est dans un état actif si le signal d'horloge interne (CK1) ne peut pas être synchronisé avec le signal d'horloge externe (CKE).

4. Procédé selon l'une des revendications 1 à 3, dans lequel chaque phase d'évaluation est précédée d'une phase de précharge de la machine d'état au cours de laquelle les signaux d'entrée (PI, SI) sont appliqués à la machine d'état (FSM), le procédé comprenant une étape d'ajustement de la durée de chaque phase de précharge à une durée minimale nécessaire à la précharge de la machine d'état.

5. Procédé selon l'une des revendications 1 à 4, dans lequel la machine d'état est réalisée à l'aide d'un réseau logique programmable (CBL), l'évaluation de la durée minimale de la phase d'évaluation étant effectuée en mesurant le temps de propagation d'un signal dans un chemin (ADc, ODc, LTc) du réseau logique programmable configuré pour être le plus lent de tous les chemins possibles des signaux dans le réseau logique programmable.

6. Procédé selon la revendication 5, dans lequel la mesure du temps de propagation d'un signal dans le chemin le plus lent (ADc, ODc, LTc) du réseau logique programmable (CBL) est effectuée en détectant un changement d'état d'un signal de sortie (LO) du chemin le plus lent.

7. Procédé selon la revendication 6, dans lequel le changement d'état du signal de sortie (LO) du chemin le plus lent (ADc, ODc, LTc) déclenche la fin de la phase d'évaluation.

8. Machine d'état (FSM) ayant un fonctionnement modélisé par un ensemble d'états reliés entre eux par des transitions, et évaluant à chaque transition durant une phase d'évaluation des signaux de sortie (PO, SO) en fonction de signaux d'entrée (PI, SI) comprenant des signaux (PI) générés lors d'une transition précédente,
**caractérisée en ce qu'**elle comprend un circuit de contrôle (CCTL, CKGN) pour mesurer une durée minimale nécessaire à l'évaluation des signaux de sortie (PO, SO) en fonction des signaux d'entrée (PI, SI), et pour ajuster la durée de la phase d'évaluation à la durée minimale mesurée.

9. Machine d'état selon la revendication 8, dans laquelle le circuit de contrôle (CCTL, CKGN) génère un signal d'horloge interne (CK1) synchronisé avec un signal d'horloge externe (CKE) appliqué à la machine d'état (FSM) pour déclencher une transition, le signal d'horloge interne ajustant la durée de chaque phase d'évaluation.

10. Machine d'état selon la revendication 8 ou 9, dans laquelle le circuit de contrôle (CCTL, CKGN) comprend des moyens pour générer un signal d'alarme qui est dans un état actif si le signal d'horloge interne (CK1) ne peut pas être synchronisé avec le signal d'horloge externe (CKE).

11. Machine d'état selon l'une des revendications 8 à 10, dans laquelle chaque phase d'évaluation est précédée par une phase de précharge de la machine d'état au cours de laquelle les signaux d'entrée (PI, SI) sont appliqués à la machine d'état (FSM), le circuit de contrôle (CCTL, CKGN) comprenant des moyens d'ajustement de la durée de chaque phase de précharge à une durée minimale nécessaire à la précharge de la machine d'état.

12. Machine d'état selon l'une des revendications 8 à 11, comprenant un réseau logique programmable (CBL) recevant les signaux d'entrée (PI, SI) de la machine d'état et générant les signaux de sortie (PO, SO) de la machine d'état en fonction des signaux d'entrée.

13. Machine d'état selon la revendication 12, dans laquelle le circuit de contrôle (CCTL) reçoit le signal d'horloge externe (CKE) et fournit le signal d'horloge interne (CK1) au réseau logique programmable (CBL).

14. Machine d'état selon l'une des revendications 8 à 13, dans laquelle le circuit de contrôle (CCTL, CKGN) comprend un chemin de signal (ADc, ODc, LTc) du réseau logique programmable (CBL), qui est configuré pour être le plus lent de tous les chemins de signaux du réseau logique programmable, pour mesurer un temps de propagation minimal d'un signal dans le réseau logique programmable, la durée de la phase d'évaluation étant ajustée à la durée minimale mesurée.

15. Machine d'état selon la revendication 14, comprenant des moyens pour détecter un changement d'état d'un signal de sortie (LO) du chemin le plus lent (ADc, ODc, LTc) du réseau logique programmable (CBL), et déclencher la fin de la phase d'évaluation à la suite du changement d'état du signal de sortie (LO) du chemin le plus lent.

16. Réseau logique programmable recevant des signaux d'entrée (E1-En) et évaluant des signaux de sortie (S1-Sp) en fonction des signaux d'entrée durant une phase d'évaluation,
**caractérisé en ce qu'**il comprend un circuit de contrôle (CCTL, CKGN) pour mesurer une durée minimale nécessaire à l'évaluation des signaux de sortie (S1-Sp) en fonction des signaux d'entrée (E1-En), et pour ajuster la durée de la phase d'évaluation à la durée minimale mesurée.

17. Réseau logique programmable selon la revendication 16, dans lequel le circuit de contrôle (CCTL, CKGN) génère un signal d'horloge interne (CK1) qui ajuste la durée de la phase d'évaluation.

18. Réseau logique programmable selon la revendication 16 ou 17, dans lequel la phase d'évaluation est précédée d'une phase de précharge au cours de laquelle les signaux d'entrée (E1-En) sont appliqués au réseau logique programmable (CBL), le circuit de contrôle (CCTL, CKGN) comprenant des moyens d'ajustement de la durée de la phase de précharge à une durée minimale nécessaire à la précharge des signaux d'entrée dans le réseau logique programmable.

19. Réseau logique programmable selon l'une des revendications 16 à 18, dans lequel le circuit de contrôle (CCTL, CKGN) comprend un chemin de signal (ADc, ODc, LTc) du réseau logique programmable (CBL), qui est configuré pour être le plus lent de tous les chemins de signaux du réseau logique programmable, pour mesurer un temps de propagation minimal d'un signal dans le réseau logique programmable, la durée de la phase d'évaluation étant ajustée à la durée minimale mesurée.

20. Réseau logique programmable selon l'une des revendications 16 à 19, comprenant des moyens pour détecter un changement d'état d'un signal de sortie (LO) du chemin le plus lent (ADc, ODc, LTc) du réseau logique programmable (CBL), et déclencher la fin de la phase d'évaluation à la suite du changement d'état du signal de sortie (LO) du chemin le plus lent.
